# EUROPEAN PATENT APPLICATION

(11) **EP 4 764 699 A1**
(43) Date of publication of application: **24.06.2026**
(21) Application number: 24220459.2
(22) Date of filing: 17.12.2024
(51) Int. Cl.: G03F 7/00, G03F 9/00

(54) **TRANSMISSION IMAGE SENSOR FOR EXPOSURE APPARATUS**

(71) Applicant: ASML Netherlands B.V., 5500 AH Veldhoven (NL)
(72) Inventor: VAN LARE, Marie-Claire, 5500 AH Veldhoven (NL); REIJNDERS, Marinus Petrus, 5500 AH Veldhoven (NL)
(74) Representative: ASML Netherlands B.V.

(57) **Abstract**

A transmission image sensor (IS1, IS2) comprises a plurality of detector gratings (66), each of the detector gratings (66) having a different pitch. A reticle grating (62) provided at reticle level has a reticle grating pitch correlated to a pattern feature on the reticle (MA).

The transmission image sensor (IS1, IS2) selects one of the plurality of detector gratings (66) having a detector grating pitch substantially corresponding to the reticle grating pitch of the reticle grating (62) as projected on a stage level of the stage (WT) of the exposure apparatus.

A position of an aerial image (60) of the reticle grating (62) at reticle level is determined using the selected one of the plurality of detector gratings (66).

## Description

### FIELD

The present invention relates to a transmission image sensor configured to be mounted to a stage of an exposure apparatus. Furthermore, the present invention relates to an substrate stage comprising said transmission image sensor, an exposure apparatus comprising substrate stage, a reticle and an alignment method of aligning a stage of an exposure apparatus using a transmission image sensor.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Plural patterns may be projected onto the substrate. A pattern to be projected on the substrate may be required to be aligned with another pattern that has previously been projected on the substrate, in order to reduce an overlay error. The lithographic apparatus may comprises an alignment sensor, such as a Transmission Image Sensor, TIS. The transmission image sensor may comprise an optical detector and a detector grating at a substrate level. The TIS sensor may be configured to measure at substrate level a position of a projected aerial image of a grating at patterning device level.

### SUMMARY

An object of the invention is to provide an accurate alignment measurement.

According to an aspect of the invention, there is provided a transmission image sensor, wherein the transmission image sensor comprises a plurality of detector gratings, each of the detector gratings having a different pitch;
wherein the transmission image sensor is configured to co-operate with a reticle grating provided at reticle level having a reticle grating pitch correlated to a pattern feature on the reticle,
the transmission image sensor comprises a control device configured to select one of the plurality of detector gratings having a detector grating pitch substantially corresponding to the reticle grating pitch of the reticle grating as projected on a stage level of the stage of the exposure apparatus,
wherein the transmission image sensor is configured to determine a position of an aerial image of the reticle grating at reticle level using the selected one of the plurality of detector gratings.

According to an aspect of the invention, there is provided a substrate stage for an exposure apparatus comprising the transmission image sensor according to the invention.

According to an aspect of the invention, there is provided an exposure apparatus comprising the substrate stage according to the invention.

According to an aspect of the invention, there is provided a reticle for an exposure apparatus, the reticle comprising a pattern to be projected onto a substrate and a grating having a pitch correlated to a pattern feature on the reticle.

According to an aspect of the invention, there is provided an alignment method of aligning a stage of an exposure apparatus using a transmission image sensor, wherein the transmission image sensor comprises a plurality of detector gratings, each of the detector gratings having a different detector grating pitch; the method comprising:
providing a reticle grating at reticle level having a reticle grating pitch correlated to a pattern feature on the reticle,
selecting one of the plurality of detector gratings having a detector grating pitch substantially corresponding to the reticle grating pitch of the grating at reticle level as projected on a stage level of the stage of the exposure apparatus,
determining a position of an aerial image of the reticle grating at reticle level using the selected one of the plurality of detector gratings.

### BRIEF DESCRIPTION OF THE DRAWINGS

Embodiments of the invention will now be described, by way of example only, with reference to the accompanying schematic drawings, in which:
- Figure 1A depicts a lithographic system comprising a lithographic apparatus and a radiation source
- Figure 1B depicts a perspective view of an exemplary method for scanning an image align sensor;
- Figure 2 highly schematically depicts gratings and a pupil on the basis of which a principle of the invention will be explained;
- Figure 3 highly schematically depicts a reticle feature, a pupil and gratings on the basis of which an embodiment of the invention will be explained;
- Figure 4 highly schematically depicts a reticle feature, a pupil and gratings on the basis of which an embodiment of the invention will be explained;
- Figure 5A - 5C depict detector gratings and detectors in accordance with embodiments of the invention;
- Figure 6 depicts arial images of reticle gratings and detector gratings in accordance with an embodiment of the invention;
- Figure 7 depicts gratings having slightly different pitches based on which a coarse positioning using a frequency difference between the gratings will be explained;
- Figure 8 depicts reticle and detector gratings having slightly different pitches based on which an example of the coarse positioning using the frequency difference between the gratings will be explained.

### DETAILED DESCRIPTION

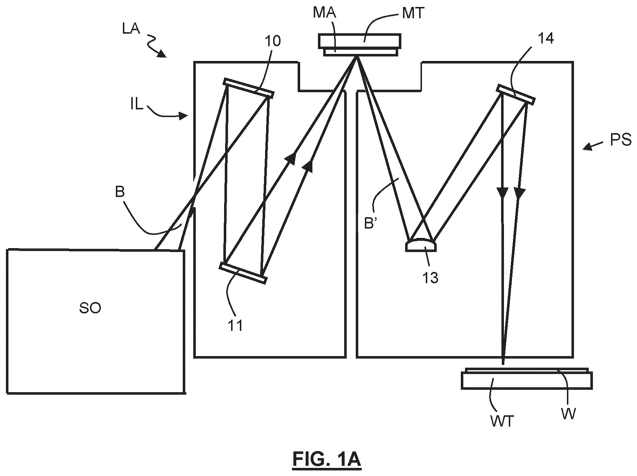

Figure 1A shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1A, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As briefly described above, a pattern to be projected on the substrate may be required to be aligned with another pattern that has previously been projected on the substrate, in order to reduce an overlay error. The lithographic apparatus may comprises an alignment sensor, such as a Transmission Image Sensor, TIS. The transmission image sensor may comprise an optical detector and a detector grating at a substrate level. The TIS sensor may be configured to cooperate with a grating at patterning device level, e.g. on the patterning device. The TIS sensor may measure a position at substrate level of a projected aerial image of the grating at patterning device level. An intensity of the detector signal measured by the detector may vary depending on an extent of alignment of the grating at the patterning device level and the detector grating. A maximum amplitude of the detector signal may be achieved when the patterns of the grating at the patterning device and the detector grating are aligned, hence resulting in a periodically increasing and decreasing detector signal, as the substrate stage is moved in respect of the patterning device, the periodicity being determined by a pitch of the grating at the patterning device level and of the detector grating.

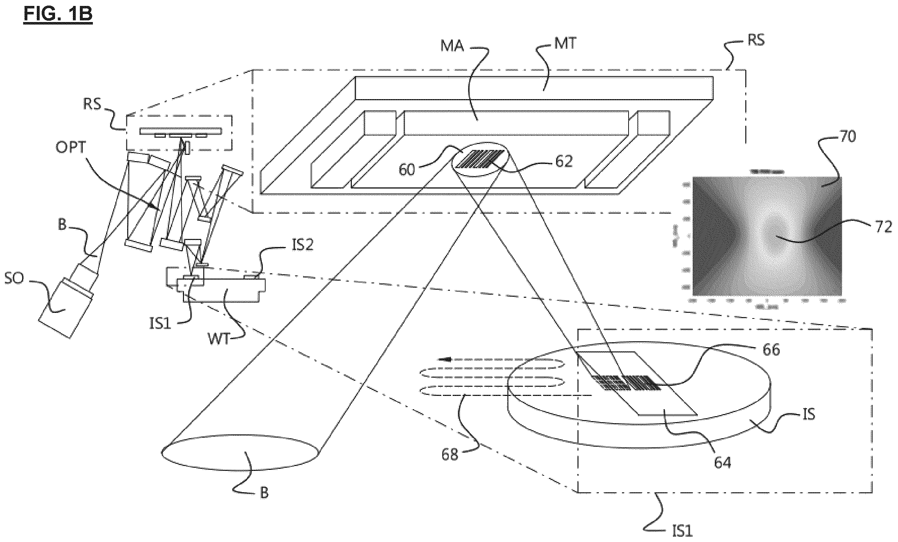

Figure 1B schematically depicts the general working principle of the one or more image align sensors IS, such as the TIS sensor. Herein, an aerial image 60 is formed at reticle level from grating marks 62 on the mask MA or one of its related components. Herein, for an EUV based application the mark may be referred to as a reticle. The functional stage comprising the reticle and its related object table MT may be referred to as the reticle stage RS.

The image 60 is then projected via the optics OPT of the lithographic apparatus onto the object stage. Herein, at least one of the image align sensors IS is positioned at the receiving end of the projection optics OPT. The image 60 is projected on the image align sensor IS, forming a projected image. The image align sensor comprises a photodetector 64 for detecting the projected image. The photodetector is provided with photodetector gratings 66.

The first sensor IS is moved across the projected beam B, for instance in a zigzag pattern 68. The patterns 68 may typically extend in horizontal direction (x-axis) and in vertical direction (z-axis), thus enabling to create an indication of radiation intensity 70 including an area of maximum radiation intensity 72. The indication of radiation intensity may be referred to as an areal image. The image align sensor basically scans the projected image, to find a position wherein the photodetector gratings 66 are aligned with the reticle gratings 62. The image align sensor IS herein provides the areal image 70. At the respective position of the object table where the respective gratings 62, 66 align, the areal image provides the maximum 72.

Herein, the scan 68 may extend over, for instance, about +/- 800 nm in vertical direction. The scan 68 may extend in horizontal direction over about +/- 200 nm. The latter is smaller than a grating pitch of the detector grating 66. The latter may be in the order of about 1 µm. The width of the scan 70 may however exceed the linewidth of the photodetector 64, which may be in the order of about 100 nm. These dimensions may be relevant for the sake of the present invention, as the scan length determines the contaminated area, eventually changing the effective duty cycle of the respective reflective grating.

The grating at the patterning device level is projected onto the substrate via the projection system. A setting of the projection system may be adapted to the pattern of the patterning device that is to be projected onto the substrate. For example, a pupil settings of the projection system may be adapted to a feature size of the features of the pattern of the patterning device.

A lithographic apparatus may have a long operating life, e.g. may be used many years, even plural decades. Semiconductor manufacturing technology may however tend to develop rather fast over time. As a result, a characteristic of the patterns that are to be projected by the lithographic apparatus, e.g. feature size, may change over time. At a smaller feature size, a desired accuracy of the alignment of the lithographic apparatus may increase, which may require a higher accuracy of the alignment measurement by the TIS sensor.

Moreover, settings of the lithographic apparatus may be adjusted over time to take the changes in e.g. feature size into account. For example, a pupil setting of the lithographic apparatus may be adjusted to take account of the smaller feature size.

When performing an alignment measurement using the TIS sensor, use is may of the projection system at the settings thereof, e.g. the pupil settings, as may be employed at the projection of the pattern of the patterning device on the substrate. Thus, as the pupil settings of the lithographic apparatus are prone to changes over time, the alignment measurement by the TIS sensor is to be performed at settings of the projection system that may be different from the settings commonly used by the projection system at the initial stage of development of the TIS sensor.

In the present document, the patterning device may also be identified as a reticle or a mask. Thus, the terms patterning device, mask and reticle may be understood as the same.

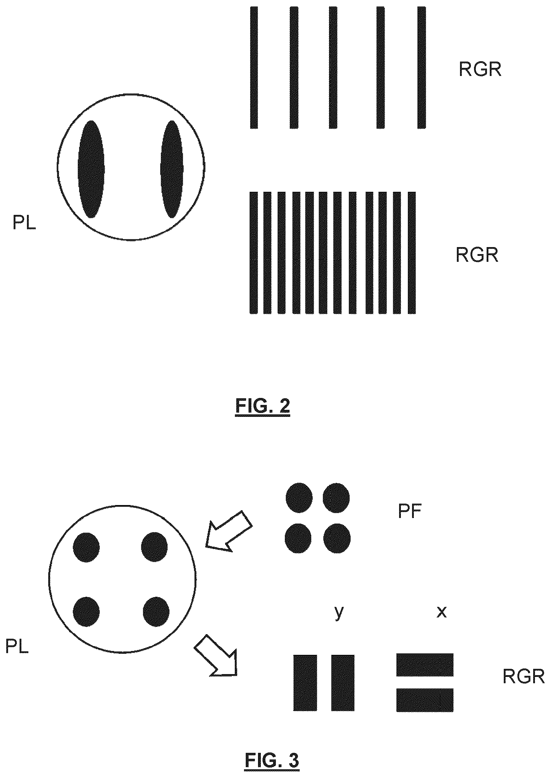

Figure 2 schematically depicts a prior art reticle grating RGR for a TIS sensor. The prior art reticle grating is configured to be projected via the projection system of the lithographic apparatus onto a detector grating DGR of the TIS sensor. The prior art detector grating may have a pitch according to a pitch of an arial image of the reticle grating on the detector grating, for example a pitch substantially corresponding to a pitch of an arial image of the reticle grating on the detector grating. Projecting the prior art TIS reticle grating onto the detector grating of the TIS sensor may be performed using the projection system PS of the lithographic apparatus, as described with reference to Figure 1A, the projection system having a pupil setting. A pupil PL of the lithographic apparatus is schematically depicted in Figure 2. The pitch of the prior art reticle grating may be variable and may be relatively large compared to size of a feature of the pattern on the reticle, for example when compared to a distance between lines that correspond to metallic traces in the pattern to be projected on the substrate. A projection of the prior art TIS reticle grating having the large variable pitch onto the detector grating may result in a high aberration sensitivity and large image asymmetries due to mask three dimensions, which may result in elevated reproduction errors.

The present invention provides a transmission image sensor which is configured to cooperate with a reticle grating at reticle level having a reticle grating pitch correlated to a pattern feature on the reticle. For example, a reticle grating may be used having a pitch which substantially corresponds to a pitch of a pattern feature at reticle level that is to be projected on the substrate, for example a pitch which substantially corresponds to a pitch of a relevant feature of the pattern at reticle level that is to be projected on the substrate. A detector grating is selected having a pitch that substantially corresponds to the reticle grating pitch of the reticle grating as projected on a stage level of the stage of the lithographic apparatus. Accordingly, a TIS grating pitch may be provided which is similar to the pitch of the pattern feature, such that it images optimally with the illumination setting An aberration sensitivity may be reduced and a more symmetric image may lead to an improved reproduction. In case of more complex pupils, pattern features, the aberration sensitivity for these structures may be simulated in combination with the intended pupil. Simulations may be performed with the same pupil for different pitch TIS marks on reticle (and different critical dimension, CD). The one with the best match in the aberration sensitivity may be selected to be printed on the reticle. Accordingly, the pitch of the reticle grating may be determined to match the intended pupil, by simulating an imaging of reticle gratings with different reticle grating pitch and/or different critical dimension using projection system settings of the exposure apparatus (e.g. pupil settings), selecting a best match in aberration sensitivity, and determining the reticle grating pitch of the reticle grating at reticle level according to the best match.

Figure 3 depicts an example of a pattern feature PF as comprised in the pattern in the patterning device, mask or reticle MA, the pattern feature in the present example may represent contact holes. A quasar pupil may be used, for example a telecentric quasar. A TIS grating at the reticle may be provided having a pitch correlated to the main pattern feature, for example having a pitch substantially the same as a pitch of the pattern feature. As depicted in Figure 3, horizontal x and vertical y reticle gratings RGR are provided having a pitch correlated with, e.g. substantially corresponding to, a horizontal and vertical pitch of the pattern feature PF.

On the one hand, an imaging quality of the imaging of the reticle grating on the detector grating may be improved resulting in relatively steep intensity gradients and a symmetric TIS image, hence a relatively large intensity difference of the TIS detector signal when moving the reticle grating relative to the detector grating. On the other hand, when moving the reticle grating relative to the detector grating, a repetition period of the detector signal may be reduced (i.e. a spatial repetition frequency being increased) according to the smaller pitch of the reticle grating and detector grating. The large intensity difference and the higher spatial repetition frequency may enable an accurate alignment of the reticle grating relative to the detector grating.

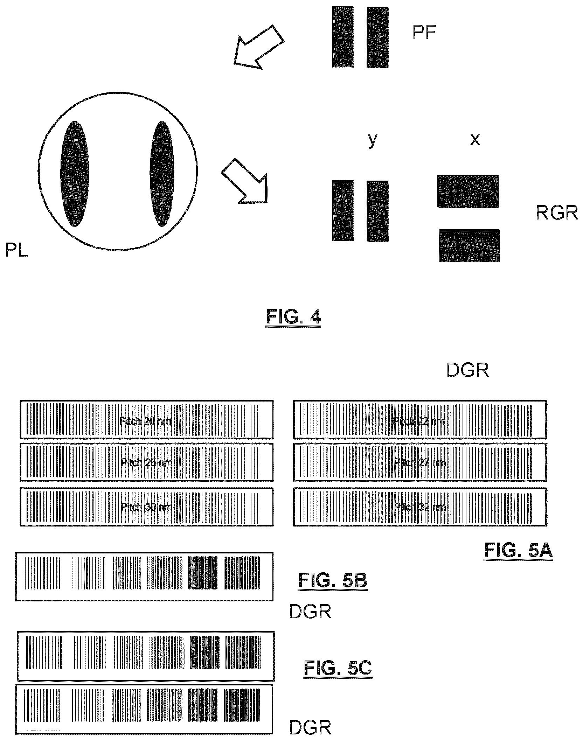

In some applications, such as in the projection of patterns that correspond to a metal layer on the substrate, a dipole pupil may be used. According to an embodiment, use may be made of a horizontal and vertical reticle grating that have a different pitch, as for example illustrated in Figure 4. Figure 4 depicts a pattern feature PF at reticle level, representing parallel metal lines extending in y direction. The vertical reticle grating RGR may have a pitch substantially the same as a pitch of a vertical feature on the reticle, e.g. representing parallel metal lines extending in the y direction. The horizontal reticle grating RGR may for example have a pitch that is larger than the pitch of the vertical reticle grating so as to correlate to the pattern of vertical parallel lines on the reticle. The horizontal and vertical reticle grating patterns are projected by the projection system PS having a dipole pupil PL stetting on the detector grating of the TIS sensor. The horizontal and vertical detector gratings are selected to have a detector grating pitch substantially corresponding to the reticle grating pitch of the reticle grating as projected on a stage level of the stage of the exposure apparatus.

In an embodiment, as illustrated above with reference to Figure 4, different reticle grating pitches and detector grating pitches in X and Y direction may be used in accordance with the different characteristics of the pattern to be projected onto the substrate, in x direction and in y direction. Accordingly, the plurality of detector gratings may comprise a plurality of x direction detector gratings having a different detector grating pitch and a plurality of y direction detector gratings having a different detector grating pitch, wherein a reticle grating with which the transmission image sensor is configured to co-operate comprises an x direction reticle grating provided at reticle level having a reticle grating pitch correlated to an x direction pattern feature on the reticle, and an y direction reticle grating provided at reticle level having a reticle grating pitch correlated to an y direction pattern feature on the reticle, wherein the control device is configured to select one of the plurality of x direction detector gratings having an x direction detector grating pitch substantially corresponding to the reticle grating pitch of the x direction grating at reticle level as projected on the stage level, and to select one of the plurality of y direction detector gratings having an y direction detector grating pitch substantially corresponding to the reticle grating pitch of the y direction grating at reticle level as projected on the stage level.

Further, the transmission image sensor may be configured to determine the position of the aerial image of the reticle grating at reticle level by determining an aligned position of the x direction grating at reticle level with the selected one of the plurality of x direction detector grating and by determining an aligned position of the y direction grating at reticle level with the selected one of the plurality of y direction detector gratings.

Following the above examples of the selection of reticle grating and detector grating pitches, the reticle grating pitch may be determined on the basis of the pupil settings of the lithographic apparatus and/or may be determined to substantially correspond to a pitch of a relevant feature of the pattern on the reticle, i.e. according to a geometry of a main reticle feature. The detector grating may be selected on the basis of the pitch of the reticle grating, hence may likewise be selected on the basis of the pupil setting of the exposure apparatus and/or may be selected to substantially correspond to a pitch of a relevant feature of the pattern on the reticle as projected on the substrate. Furthermore, as described above, an optical simulation may be performed, and a pitch (and CD) of the TIS mark may be determined to match as close as possible to aberration sensitivities of pattern. An alternative to simulation may be to measure the aberration sensitivity of different TIS marks in the exposure apparatus. The measurement may be performed by dialing in lens aberrations in the projection lens, and measuring the observed position shift of the aligned position of the TIS sensor for different TIS marks. This may require that multiple different TIS marks are printed on the reticle or a representative fiducial fixed in the exposure apparatus.

For example, the pitch of the reticle grating and/or the detector grating may be selected on the basis of a lookup table responsive to the pupil setting of the exposure apparatus.

The selection of the detector grating may be performed by a control device of the TIS sensor. For example, the control device may position the stage of the lithographic apparatus to provide that the reticle grating is projected by the projection system onto the selected detector grating.

Figure 5A - 5C depict examples of plural detector gratings DGR having different pitches. Figure 5A depicts an example of plural TIS sensor detectors, each provided with a detector grating, the detector gratings having incremental pitches, such as for example in a range of 20 - 32 nm, e.g. 20nm, 22nm, 25nm, 27 nm, 30nm, 32nm. A detector grating may be selected by projecting the reticle grating on the respective detector. Figure 5B depicts an example of a single TIS sensor detector, provided with plural detector grating, the detector gratings having incremental pitches, such as for example in a range of 20 - 40 nm, e.g. 20nm, 24nm, 28nm, 32 nm, 36nm, 40nm. A detector grating may be selected by imaging the reticle grating on the respective detector grating. Figure 5C depicts an example of dual TIS sensor detectors, each provided with plural detector grating, the detector gratings having incremental pitches, such as for example a first detector having gratings with a first subset of pitches in a range and a second detector having gratings with a second subset of pitches in the range. The third example accordingly provides a combination of the embodiments according to Figure 5A and 5B. A detector grating may be selected by imaging the reticle grating on the respective detector grating of the respective detector.

Using the reticle grating and detector grating according to the present invention, a capture range of the TIS sensor may become smaller due to the smaller pitches. As the grating is periodic, a period error may occur. In an embodiment, two of the detector gratings are selected and used by the TIS sensor in the alignment measurement in order to increase a capture range.

Accordingly, in an embodiment, the control device is further configured to select a further one of the plurality of detector gratings having a detector grating pitch different from the detector grating pitch of the selected one of the plurality of detector gratings and wherein the transmission image sensor is configured to determine a coarse position of the aerial image of the reticle grating using the selected further one of the plurality of detector gratings.

For example, the detector grating pitch of the selected further one of the plurality of detector gratings is substantially larger than the detector grating pitch of the selected one of the plurality of detector gratings. The detector grating with the substantially larger pitch may be used to perform a coarse alignment measurement, which may be combined with the more accurate alignment measurement using the selected detector grating.

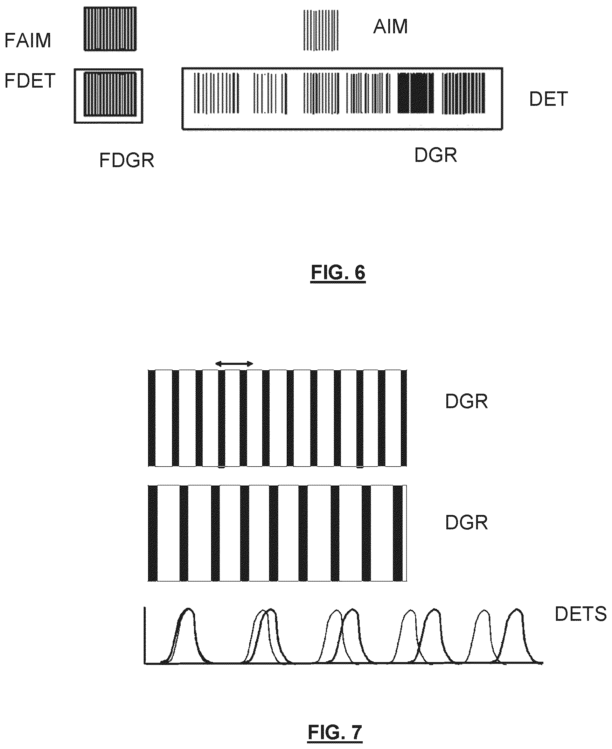

For example figure 6 depicts a detector DET (such as a photodiode) of the TIS sensor, the detector being provided with plural detector gratings DGR having different pitches, and a further detector FDET of the TIS sensor having a further detector grating FDGR with a larger detector grating pitch. An arial image AIM of the reticle grating is projected on a selected one of the detector gratings DGR of the detector DET, the selected detector grating having a detector grating pitch corresponding to a pitch of the arial image AIM of the reticle grating. An arial image of a further reticle grating having a larger pitch the arial image being indicated in figure 6 by FAIM, may be projected onto the further detector FDET having a corresponding larger reticle grating pitch. Due to the larger reticle grating pitch of the further detector, a lower spatial repetition frequency of the detector signal of the further detector may be provided, resulting in a large capture range, on the basis of which a coarse alignment may be performed, which may be combined with a fine alignment by the projection of the arial image AIM on the selected detector grating DGR of the detector DET.

As an alternative, use may be made of two detector gratings having an incrementally different spatial frequency of the pitch thereof, whereby a coarse positioning may be performed on the basis of a spatial frequency difference. For example, the detector grating pitch of the selected further one of the plurality of detector gratings is incrementally different from the detector grating pitch of the selected one of the plurality of detector gratings and the transmission image sensor may be configured to determine the coarse position using a spatial frequency difference between the detector grating pitch of the selected one of the plurality of detector gratings and the detector grating pitch of the selected further one of the plurality of detector gratings.

For example, figure 7 depicts dual gratings DGR having a minor difference in pitch, i.e. a minor difference in spatial frequency of the gratings. As shown in the response curve of the detector signal DETS, from a relative shift between the gratings, a coarse position may be determined, providing a capture range determined by the frequency difference between the spatial frequencies.

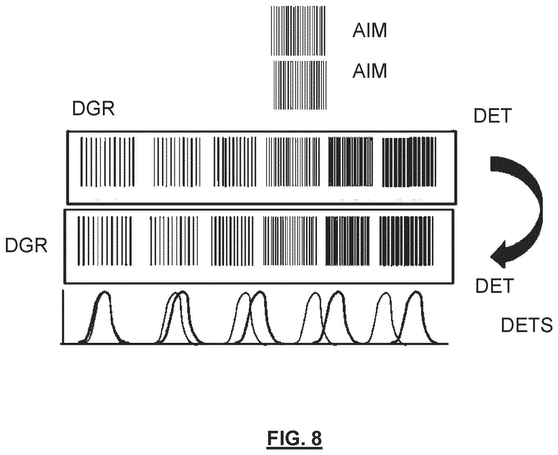

As a practical example, as illustrated in figure 8, when combining different pitches over a same detector, as described above with reference to Figure 5B, two reticle gratings having different pitches may be used. An arial image AIM of each reticle grating is projected onto a respective detector DET, the one reticle grating projected onto a corresponding, selected detector grating of the one detector and the other reticle grating projected onto a corresponding, selected detector grating of the other detector. As shown in the response curve of the detector signal DETS, from a relative shift between the gratings, a coarse position may be determined, providing a capture range determined by the frequency difference between the spatial frequencies of the arial images.

According to an aspect of the invention, there is provided a stage for an exposure apparatus, the stage comprising the transmission image sensor according to the invention. The stage may for example comprise a substrate stage configured to hold the substrate.

According to an aspect of the invention, there is provided an exposure apparatus comprising the substrate stage according to the invention. The exposure apparatus may for example comprise a lithographic apparatus.

According to an aspect of the invention, there is provided a reticle for an exposure apparatus, the reticle comprising a pattern to be projected onto a substrate and a grating having a pitch correlated to a pattern feature on the reticle.

In an embodiment, the exposure apparatus may loaded with the reticle according to the invention.

According to an aspect of the invention, there is provided an alignment method of aligning a stage of an exposure apparatus using a transmission image sensor, wherein the transmission image sensor comprises a plurality of detector gratings, each of the detector gratings having a different detector grating pitch; the method comprising:
providing a reticle grating at reticle level having a reticle grating pitch correlated to a pattern feature on the reticle,
selecting one of the plurality of detector gratings having a detector grating pitch substantially corresponding to the reticle grating pitch of the grating at reticle level as projected on a stage level of the stage of the exposure apparatus,
determining a position of an aerial image of the reticle grating at reticle level using the selected one of the plurality of detector gratings.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. Transmission image sensor, wherein the transmission image sensor comprises a plurality of detector gratings, each of the detector gratings having a different pitch;
wherein the transmission image sensor is configured to co-operate with a reticle grating provided at reticle level having a reticle grating pitch correlated to a pattern feature on the reticle,
the transmission image sensor comprises a control device configured to select one of the plurality of detector gratings having a detector grating pitch substantially corresponding to the reticle grating pitch of the reticle grating as projected on a stage level of the stage of the exposure apparatus,
wherein the transmission image sensor is configured to determine a position of an aerial image of the reticle grating at reticle level using the selected one of the plurality of detector gratings.

2. The transmission image sensor according to any one of the preceding claims, wherein the control device is configured to select the one of the plurality of detector gratings on the basis of a pupil setting of the exposure apparatus .

3. The transmission image sensor according to claim 2, wherein the control device is configured to select the one of the plurality of detector gratings on the basis of a lookup table responsive to the pupil setting of the exposure apparatus.

4. The transmission image sensor according to any one of the preceding claims, wherein the control device is further configured to select a further one of the plurality of detector gratings having a detector grating pitch different from the detector grating pitch of the selected one of the plurality of detector gratings and wherein the transmission image sensor is configured to determine a coarse position of the aerial image of the reticle grating using the selected further one of the plurality of detector gratings.

5. The transmission image sensor according to claim 4, wherein the detector grating pitch of the selected further one of the plurality of detector gratings is substantially larger than the detector grating pitch of the selected one of the plurality of detector gratings.

6. The transmission image sensor according to claim 4, wherein the detector grating pitch of the selected further one of the plurality of detector gratings is incrementally different from the detector grating pitch of the selected one of the plurality of detector gratings and wherein the transmission image sensor is configured to determine the coarse position using a spatial frequency difference between the detector grating pitch of the selected one of the plurality of detector gratings and the detector grating pitch of the selected further one of the plurality of detector gratings.

7. The transmission image sensor according to any one of the preceding claims, wherein the plurality of detector gratings comprises a plurality of x direction detector gratings having a different detector grating pitch and a plurality of y direction detector gratings having a different detector grating pitch,
wherein reticle grating with which the transmission image sensor is configured to co-operate comprises an x direction reticle grating provided at reticle level having a reticle grating pitch correlated to an x direction pattern feature on the reticle, and an y direction reticle grating provided at reticle level having a reticle grating pitch correlated to an y direction pattern feature on the reticle,
wherein the control device is configured to select one of the plurality of x direction detector gratings having an x direction detector grating pitch substantially corresponding to the reticle grating pitch of the x direction grating at reticle level as projected on the stage level, and to select one of the plurality of y direction detector gratings having an y direction detector grating pitch substantially corresponding to the reticle grating pitch of the y direction grating at reticle level as projected on the stage level.

8. The transmission image sensor according to claim 7, wherein the transmission image sensor is configured to determine the position of the aerial image of the reticle grating at reticle level by determining an aligned position of the x direction grating at reticle level with the selected one of the plurality of x direction detector grating and by determining an aligned position of the y direction grating at reticle level with the selected one of the plurality of y direction detector gratings.

9. The transmission image sensor according to any one of the preceding claims, wherein at least two of the plurality of detector gratings are arranged to project onto a same photodetector of the transmission image sensor.

10. The transmission image sensor according to any one of the preceding claims, wherein at least two of the plurality of detector gratings are arranged to project onto different photodetectors of the transmission image sensor.

11. A substrate stage for an exposure apparatus comprising the transmission image sensor according to any one of the preceding claims.

12. An exposure apparatus comprising the substrate stage according to claim 11.

13. A reticle for an exposure apparatus, the reticle comprising a pattern to be projected onto a substrate and a grating having a pitch correlated to a pattern feature on the reticle.

14. The exposure apparatus according to claim 12 loaded with the reticle according to claim 13.

15. An alignment method of aligning a stage of an exposure apparatus using a transmission image sensor, wherein the transmission image sensor comprises a plurality of detector gratings, each of the detector gratings having a different detector grating pitch; the method comprising:
providing a reticle grating at reticle level having a reticle grating pitch correlated to a pattern feature on the reticle,
selecting one of the plurality of detector gratings having a detector grating pitch substantially corresponding to the reticle grating pitch of the grating at reticle level as projected on a stage level of the stage of the exposure apparatus,
determining a position of an aerial image of the reticle grating at reticle level using the selected one of the plurality of detector gratings.

16. The alignment method according to claim 15, comprising simulating an imaging of reticle gratings with different reticle grating pitch and/or different critical dimension using projection system settings of the exposure apparatus, selecting a best match in aberration sensitivity, and determining the reticle grating pitch of the reticle grating at reticle level according to the best match.

17. The alignment method according to claim 15, comprising determining the reticle grating pitch of the reticle grating at reticle level according to a geometry of a main reticle feature.
